# EUROPEAN PATENT APPLICATION

(11) **EP 4 831 665 A1**
(43) Date of publication of application: **28.10.2026**
(21) Application number: 25845191.3
(22) Date of filing: 07.07.2025
(51) Int. Cl.: G01R 31/392, G01R 31/396, G01R 31/382, G01R 31/388, G01R 31/367, G01R 19/10, G01R 19/12, G01R 19/165, B60L 58/16

(54) **ELECTRONIC DEVICE AND OPERATING METHOD THEREOF**

(30) Priority: 24.07.2024 KR 20240098046
(71) Applicant: LG Energy Solution, Ltd., Seoul 07335 (KR)
(72) Inventor: KIM, Kihoon, Daejeon 34122 (KR); KIM, Changhoon, Daejeon 34122 (KR)
(74) Representative: Goddar, Heinz J.
(86) International application number: PCT/KR2025/009757
(87) International publication number: WO 2026/023927

(57) **Abstract**

This electronic device comprises: an information acquisition interface; a memory for storing one or more instructions; and a processor, wherein, when executed, the one or more instructions can instruct the processor to: determine, each time a vehicle is driven, a compensation voltage of each of a plurality of battery cells on the basis of balancing data; determine an accumulated compensation voltage by accumulating the compensation voltage for a predetermined period; acquire a first voltage of each of the plurality of battery cells at a diagnosis time point; determine a second voltage of each of the plurality of battery cells on the basis of the first voltage and the accumulated compensation voltage; determine a voltage deviation of each of the plurality of battery cells on the basis of a reference voltage and the second voltage; determine the amount of change in the voltage deviation according to the predetermined period; and diagnose the state of each of the plurality of battery cells on the basis of the amount of change in the voltage deviation.

## Description

### Technical Field

This application claims the benefit of Korean Patent Application No. 10-2024-0098046, filed on July 24, 2024, in the Korean Intellectual Property Office, the disclosure of which is incorporated herein by reference in its entirety.

Example embodiments in the present disclosure relate to an electronic apparatus and an operating method thereof.

### Background Art

Recently, research and development of secondary batteries is being actively performed. Here, the secondary batteries are batteries that may be charged and discharged, the meaning of which incorporates all of Ni/Cd batteries, Ni/MH batteries and the like of prior art and recent lithium-ion batteries. Among the secondary batteries, the lithium-ion batteries have an advantage of providing a significantly high energy density compared to the Ni/Cd batteries, the Ni/MH batteries and the like of prior art. Furthermore, the lithium-ion batteries may be manufactured in a small size and with a light weight to be used as a power source of a mobile device, and have the range of use thereof being recently expanded to a power source of an electric vehicle, thereby coming to the fore as a next-generation energy storage medium.

When a micro-short circuit is generated in such a battery, a leakage current of the corresponding battery may be generated. In a case in which a leakage current has been generated because of a generation of an internal micro-short circuit of any one battery, a voltage of the corresponding battery may be gradually reduced compared to a voltage of another battery. And, when such a situation continues, a hard short circuit may be generated, thereby inflicting a permanent damage to a battery pack.

### Detailed Description of the Invention

### Technical Goals

An objective of example embodiments of the present disclosure is to provide an electronic apparatus which diagnoses a state of a battery cell by considering a state change due to balancing and an operating method thereof.

Further, an objective of example embodiments of the present disclosure is to provide an electronic apparatus which may diagnose a battery cell by precisely reflecting a state change due to balancing even in a case in which a state-of-charge (SOC)-voltage graph is not linear depending on a construction of a battery cell and an operating method thereof.

Technical goals of the example embodiments of the present disclosure are not limited to the aforementioned technical goals, and other unstated technical goals may be clearly understood by those who are skilled in the art from descriptions below.

### Technical solutions

According to an example embodiment in the present disclosure, there is provided an electronic apparatus including an information obtaining interface obtaining a voltage of a plurality of battery cells included in a battery pack of a vehicle, and balancing data of the plurality of battery cells, a memory storing at least one instruction, and a processor, wherein, when the at least one instruction is executed, the processor is configured to determine, at each operation of the vehicle, a compensation voltage of each of the plurality of battery cells based on the balancing data, determine, by accumulating the compensation voltage of each of the plurality of battery cells during a predetermined cycle, a cumulative compensation voltage of each of a plurality of battery cells, obtain a first voltage of each of the plurality of battery cells at a point in time of diagnosis, determine, based on the first voltage and the cumulative compensation voltage of each of the plurality of battery cells, a second voltage of each of the plurality of battery cells, determine, based on a reference voltage and the second voltage of each of the plurality of battery cells, a voltage deviation of each of the plurality of battery cells, determine, with respect to each of the plurality of battery cells, a variation of the voltage deviation according to the predetermined cycle, and diagnose, based on the variation of the voltage deviation of each of the plurality of battery cells, a state of each of the plurality of battery cells.

According to an example embodiment, the processor is configured to determine, at each operation of the vehicle, a compensation capacity of each of the plurality of battery cells based on the balancing data, identify a starting state-of-charge (SOC) and an ending SOC of each of the plurality of battery cells, determine a reference SOC based on the starting SOC and the ending SOC, and determine, based on the reference SOC and the compensation capacity, the compensation voltage of each of the plurality of battery cells.

According to an example embodiment, the processor is configured to determine, based on the balancing data, balancing time of each of the plurality of battery cells, determine, based on a balancing current and the balancing time of each of the plurality of battery cells, a balancing capacity of each of the plurality of battery cells, and determine, based on a rated capacity and the balancing capacity of each of the plurality of battery cells, the compensation capacity.

According to an example embodiment, the processor is configured to determine, based on a balancing current and a voltage of each of a plurality of battery cells, the balancing time of each of the plurality of battery cells.

According to an example embodiment, the processor is configured to determine a difference between a voltage corresponding to the reference SOC and a voltage corresponding to a compensation SOC obtained by adding the compensation capacity to the reference SOC, as the compensation voltage of each of the plurality of battery cells.

According to an example embodiment, the reference SOC is set with an average of the starting SOC and the ending SOC.

According to an example embodiment, the reference SOC is set as an SOC corresponding to a point at which a linearity of a graph indicating a relation between a voltage and an SOC of a battery cell is greatest in a section between the starting SOC and the ending SOC.

According to an example embodiment, the processor is configured to determine the second voltage of each of the plurality of battery cells by adding the cumulative compensation voltage to the first voltage of each of the plurality of battery cells.

According to an example embodiment, the processor is configured to determine an average of the second voltage of the plurality of battery cells as the reference voltage, and determine a difference between the reference voltage and the second voltage of each of the plurality of battery cells as the voltage deviation of each of the plurality of battery cells.

According to an example embodiment, the processor is configured to diagnose the plurality of battery cells by comparing a pattern of the variation of the voltage deviation of each of the plurality of battery cells to a predetermined diagnosis pattern.

According to an example embodiment of the present disclosure, an operating method of an electronic apparatus includes obtaining a voltage of a plurality of battery cells included in a battery pack of a vehicle and balancing data of the plurality of battery cells, determining, at each operation of the vehicle, a compensation voltage of each of the plurality of battery cells based on the balancing data, determining, by accumulating the compensation voltage of each of the plurality of battery cells during a predetermined cycle, a cumulative compensation voltage of each of a plurality of battery cells, obtaining a first voltage of each of the plurality of battery cells at a point in time of diagnosis, determining, based on the first voltage and the cumulative compensation voltage of each of the plurality of battery cells, a second voltage of each of the plurality of battery cells, determining, based on a reference voltage and the second voltage of each of the plurality of battery cells, a voltage deviation of each of the plurality of battery cells, determining, with respect to each of the plurality of battery cells, a variation of the voltage deviation according to the predetermined cycle, and diagnosing, based on the variation of the voltage deviation of each of the plurality of battery cells, a state of each of the plurality of battery cells.

### Effects of the Invention

According to an electronic apparatus and an operating method thereof in example embodiments of the present disclosure, it is possible to more accurately and precisely diagnose an abnormality of each battery cell by using balancing data.

Other than this effect, various effects which are directly or indirectly recognized through the present disclosure may be provided.

### Brief Description of Drawings

FIG. 1 is a block diagram illustrating a configuration of an electronic apparatus according to an example embodiment of the present disclosure.
FIG. 2 is a drawing illustrating an example of an SOC-voltage graphs of battery cells according to an example embodiment of the present disclosure.
FIG. 3 is a drawing illustrating an example of determining a cumulative compensation voltage of a battery cell according to an example embodiment of the present disclosure.
FIG. 4 is a drawing illustrating an example of determining a voltage deviation of a plurality of battery cells according to an example embodiment of the present disclosure.
FIG. 5 is a drawing illustrating an example of determining a variation of a voltage deviation of a battery cell according to an example embodiment of the present disclosure.
FIG. 6 to FIG. 9 are drawings illustrating an example of comparing a variation of a voltage deviation to a diagnosis pattern according to an example embodiment of the present disclosure.
FIG. 10 is a flowchart for illustrating a diagnosing method of an electronic apparatus according to an example embodiment of the present disclosure.

### Mode for Carrying Out the Invention

The following description of various example embodiments disclosed in this document is provided with reference to the accompanying drawings. However, this is not intended to limit the present disclosure to any specific example embodiment, and it is to be understood that various modifications, equivalents, and/or alternatives of example embodiments of the present disclosure are included within the scope of the present disclosure.

In this document, singular forms of nouns corresponding to items may include both singular and plural forms unless the context clearly indicates otherwise. In this document, expressions such as "A or B," "at least one of A and B," "at least one of A or B," "A, B, or C," "at least one of A, B, and C," and "at least one of A, B, or C" are intended to include any one of the listed items or any combination of two or more of the listed items. Terms such as "first," "second," "primary," or "secondary" may be used merely to differentiate one element from another element and are not intended to limit the elements by importance, order, or any other attribute. When a certain (for example, first) element is said to be "coupled" or "connected" to another (for example, second) element, with or without terms such as "functionally" or "communicatively," it means that the certain element may be connected to the other element directly (for example, via a wired connection), wirelessly, or through a third element.

Each of the elements (for example, modules or programs) described in the present disclosure may include a single entity or a plurality of entities. According to various example embodiments, one or more of the elements or operations may be omitted, or one or more other elements or operations may be added. Alternatively or additionally, a plurality of elements (for example, modules or programs) may be integrated into a single element. In such a case, the integrated element may be capable of performing one or more functions of each of the plurality of elements in the same or similar manner as performed by the corresponding elements among the plurality of elements before the integration. According to various example embodiments, operations performed by a module, a program, or other elements may be executed sequentially, in parallel, repeatedly, or heuristically, and one or more of the operations may be executed in a different order, omitted, or supplemented with one or more additional operations.

In this document, the terms "module" or "...part" may include a unit implemented in hardware, software, or firmware, and may be used interchangeably with terms such as logic, a logic block, a part, or a circuit. A module may be an integrated part, or a minimum unit or a portion thereof, which performs one or more functions. For example, according to an example embodiment, a module may be implemented in an application-specific integrated circuit (ASIC) form.

Various example embodiments of the present document may be implemented as software (for example, a program or an application) that includes one or more instructions stored in a machine-readable storage medium (for example, a memory). For example, a processor of a device may call and execute at least one instruction among the one or more instructions stored in the storage medium. This enables the device to be operated to perform at least one function according to the at least one instruction called. The one or more instructions may include a code generated by a compiler or a code that may be executed by an interpreter. The machine-readable storage medium may be provided in a non-transitory storage medium form. Here, 'non-transitory' merely means that the storage medium is a tangible device and does not include a signal (for example, an electromagnetic wave), and the term does not distinguish between a case where data are stored semi-permanently in the storage medium and a case where data are stored temporarily.

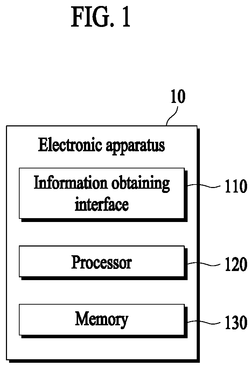

FIG. 1 is a block diagram illustrating a configuration of an electronic apparatus according to an example embodiment of the present disclosure.

Referring to FIG. 1, an electronic apparatus 10 may include an information obtaining interface 110, a processor 120, and a memory 130.

The electronic apparatus 10 may diagnose a state of each of a plurality of battery cells included in a battery pack. The electronic apparatus 10 may diagnose a state of a battery cell to distinguish a cell at which an abnormality has occurred. For instance, the electronic apparatus 10 may distinguish a cell at which an internal micro-short circuit abnormality has occurred among battery cells included in a battery pack.

At a battery pack, a plurality of battery cells may be serially and/or parallelly arranged in a row, and, depending on cases, a battery pack may be constituted in a battery bank (or module) unit, which is assembly of battery cells.

At a battery pack, a nonuniformity (for instance, voltage nonuniformity) state between battery cells may occur, and a balancing operation may be performed to resolve the nonuniformity state between the battery cells. Here, the balancing operation may be largely divided into passive balancing and active balancing. Firstly, the active balancing may be understood as a concept of re-distributing energy between the battery cells. For instance, by the active balancing, energy of a particular cell may be re-distributed to a low-voltage or low-capacity cell. The passive balancing may be understood as a concept of achieving uniformity of the battery cells by discharging energy from high voltage cells as heat. For instance, the passive balancing may achieve uniformity with a low-voltage or low-capacity battery cell by reducing energy of a battery cell having a higher voltage or greater capacity than the low-voltage or low-capacity battery cell. As an example, the passive balancing may reduce a voltage or a capacity through a discharge of a battery cell which is a target by using a balancing circuit connected to each battery cell.

Therefore, a state of a battery cell may be changed by a balancing operation in a battery pack. For instance, a voltage and a capacity of a battery cell at which the passive balancing is performed may be reduced while the balancing is performed. Therefore, the electronic apparatus 10 may correct a voltage of each cell at a point in time of diagnosis by considering a state change of each battery cell due to balancing, and analyze the corrected voltage in order to individually diagnose the battery cell. In other words, the electronic apparatus 10 may more precisely diagnose a state of a battery cell by considering a state of each battery cell which is changed as balancing is performed at a battery pack.

The electronic apparatus 10 may use an SOC-voltage graph indicating a characteristic of a battery cell to compensate for a state change due to balancing at a battery pack. Nevertheless, depending on a construction of a battery cell, the SOC-voltage graph may not be linear, and an inclination thereof may not be uniform. In a case in which an SOC-voltage graph of a battery cell is not linear, depending on a point in time at which a state change due to balancing is compensated, a significant difference may exist at a state variation to be compensated (for instance, a compensation voltage). For instance, in a case in which a state change due to balancing is compensated at a point at which an inclination of an SOC-voltage graph is great, even when the point only slightly alters, a state variation to be compensated may significantly alter.

Therefore, the electronic apparatus 10 may determine a compensation voltage at each operation, and correct a voltage of a battery cell at a point in time of diagnosis by accumulating the same, thereby reducing a compensation voltage error caused by a difference of an inclination of an SOC-voltage graph even when the graph of the battery cell is not linear. Accordingly, the electronic apparatus 10 may prevent over-inspection and may increase accuracy of a diagnosis when a battery cell is diagnosed.

The following description will be provided with a balancing operation at a battery pack being assumed as the passive balancing. Nevertheless, it will also be noted that an operation of the electronic apparatus 10 hereinafter may be identically applied even in a case in which a balancing operation is performed as the active balancing.

The electronic apparatus 10 may signify a battery diagnosing apparatus performing a diagnosis of a battery cell, and an operation of the electronic apparatus 10 may be performed in various devices such as a battery management system (BMS) of a battery pack, a BMS of a vehicle, a server or a cloud connected to a vehicle on which a battery pack is mounted, a charger, a charger and discharger and the like.

Hereinafter, an operation of the electronic apparatus 10 will be more specifically described.

The information obtaining interface 110 may obtain voltage and balancing data of a plurality of battery cells included in a battery pack. The voltage data of a plurality of battery cells may signify an operating voltage or an open circuit voltage (OCV) of each battery cell. For instance, the information obtaining interface 110 may obtain an operating voltage of a battery cell when a vehicle is operated, and may obtain an OCV of a battery cell during a pause state of a battery pack.

Further, the balancing data of a plurality of battery cells may include data related to a state change of each battery cell which occurs during a balancing operation of a battery pack. For instance, the information obtaining interface 110 may obtain a state of each battery cell, which changes in a balancing operation during the balancing operation of the battery cell, as the balancing data. Further, the balancing data may include data obtained by matching an operation of a vehicle with a state change of a battery cell. For instance, the balancing data may include data obtained by matching an SOC change of a battery cell in an operation section of a vehicle. Here, the operation section of a vehicle may signify a section from a point in time at which the vehicle is started to a point in time at which the same is turned off.

For instance, the balancing data may include at least one portion of capacity change data of a battery cell, SOC change data, voltage change data and balancing time data. For instance, the information obtaining interface 110 may obtain data with respect to a changing capacity of a battery cell during a balancing process, data with respect to a changing SOC, and data with respect to a changing voltage. Further, the information obtaining interface 110 may obtain data with respect to balancing time during which each balancing operation continues, and a balancing current.

Further, the balancing data may include data obtained by matching an SOC change of a battery cell with an operation section of a vehicle. Here, the operation section of a vehicle may signify a section from a point in time at which the vehicle is started to a point in time at which the same is turned off.

The information obtaining interface 110 may, depending on cases, further obtain data such as a temperature of a battery pack, a state-of-health (SOH) and the like other than the voltage data and the balancing data of a battery cell.

The information obtaining interface 110 may, in a case in which the electronic apparatus 10 is a BMS of a battery pack, be a configuration directly measuring a state of a battery pack, for instance, a sensor and the like. Further, in a case in which the electronic apparatus 10 is a vehicle BMS, a server, a cloud, a charger and discharger and the like, the information obtaining interface 110 may be a communication interface receiving information from a configuration measuring a state of a battery pack and the like (for instance, a BMS of a battery pack).

The memory 130 may store various data used by at least one element (e.g., the processor 120). The memory 130 may store instructions with respect to an operation of the processor 120. A program may be stored in the memory 130 as software, and may include, for instance, an operating system, middleware or an application. Unless stated otherwise, in the present disclosure, the memory 130 may signify assembly of at least one memory 130. For instance, the memory 130 may store the voltage and balancing data of a battery cell obtained from the information obtaining interface 110. Further, the memory 130 may store an SOC-voltage graph of a battery cell.

The processor 120 may be a configuration which may perform data processing or calculation with respect to communication and/or control of each element of the electronic apparatus 10, and may be operatively connected to elements of the electronic apparatus 10. The processor 120 may load instructions or data received from other elements of the electronic apparatus 10 in the memory 130, process instructions or data stored in the memory 130, and store result data. Unless stated otherwise, in the present disclosure, the processor 120 may signify assembly of at least one processor 120.

According to an example embodiment, the processor 120 may determine a compensation voltage of each of a plurality of battery cells based on balancing data of the plurality of battery cells at each operation of a vehicle.

During a process of diagnosing each battery cell, the processor 120 may, in order to compensate for a state change of a battery cell due to balancing, determine a compensation voltage of each of a plurality of battery cells at each operation of a vehicle. The processor 120 may, by individually determining a compensation voltage of a battery cell due to balancing at each operation of a vehicle, more precisely and objectively analyze a state of the battery cell, and, accordingly, increase precision in diagnosis.

Further, the processor 120 may determine a compensation voltage at each operation, rather than estimating a long-term state change of a battery cell at once, thereby more precisely reflecting an actual state change of a battery cell to determine the compensation voltage. Accordingly, it may be prevented that a required compensation voltage according to an actual state change of a battery cell at a point in time of diagnosis of the battery cell and a compensation voltage determined by the processor 120 from being significantly different.

According to an example embodiment, the processor 120 may determine a compensation capacity of each of a plurality of battery cells based on balancing data at each operation of a vehicle. In order to determine a compensation voltage of a battery cell at each operation, the processor 120 may determine a compensation capacity of each battery cell, and determine a compensation voltage corresponding to the compensation capacity.

A compensation capacity of a battery cell may be a value of each battery cell corresponding to a capacity ratio by which each battery cell decreases or increases due to balancing. For instance, when a capacity of a particular battery cell has decreased by 2 percent (%) due to balancing during an operation process, a compensation capacity may be determined as 2% corresponding to the capacity which has decreased.

According to an example embodiment, the processor 120 may determine a balancing capacity indicating a state change of each of a plurality of battery cells due to balancing, and determine a compensation capacity indicating a degree of a state changing due to balancing based on the balancing capacity of each battery cell.

According to an example embodiment, the processor 120 may determine a balancing capacity of each battery cell based on a balancing current and balancing time of each of a plurality of battery cells. The balancing current may be determined in a designing step of a battery pack, and may be set to be identical for all battery cells. As an example, the balancing current may be set at 0.025 amperes (A). Further, the balancing time may signify time during which balancing of each battery cell is performed.

For instance, the processor 120 may determine a balancing capacity of each battery cell by the following [Equation 1]. [Equation 1] $Balancing capacity = balancing time * balancing current$

The processor 120 may, in a case in which a plurality of balancings are performed during an operation process, accumulate a balancing capacity which is determined as described above for each balancing.

According to an example embodiment, the processor 120 may determine balancing time of each of a plurality of battery cells based on balancing data. The processor 120 may determine balancing time of each battery cell as a process for determining a balancing capacity of each battery cell.

For instance, the processor 120 may identify balancing starting time and balancing ending time of each battery cell from balancing data obtained from the information obtaining interface 110, and may determine a difference between the balancing starting time and the balancing ending time as balancing time of each battery cell. As an instance, the processor 120 may, at each balancing operation, identify a battery cell at which balancing is performed, and identify balancing starting time and ending time of a battery cell at which balancing is performed. Also, the processor 120 may determine an interval between the balancing starting time and ending time as balancing time.

According to an example embodiment, the processor 120 may determine balancing time of each of a plurality of battery cells based on a voltage and a balancing current of each of the plurality of battery cells. For instance, the processor 120 may determine balancing time of each battery cell at an operation starting point in time. This is merely an example, and the processor 120 may determine balancing time at a balancing starting point in time other than the operation starting point in time.

For instance, the processor 120 may identify a voltage of each battery cell at the operation starting point in time, and may identify a voltage which corresponds to a balancing ending condition of the battery cell and a deviation of each battery cell. For instance, a voltage which corresponds to a balancing ending condition may be a voltage which is lowest among voltages of a plurality of battery cells. With respect to each of a plurality of battery cells, the processor 120 may determine balancing time which is required for balancing until a voltage of each battery cell reaches a voltage which corresponds to an ending condition from a voltage and a balancing current of each thereof. As an example, the processor 120 may determine an electric power consumption which is required in order for a voltage of each battery cell to reach a voltage which corresponds to an ending condition, and may determine balancing time corresponding thereto.

Depending on cases, the processor 120 may estimate operation time of a vehicle as balancing time.

According to an example embodiment, the processor 120 may determine a compensation capacity of each battery cell based on a rated capacity and a balancing capacity of each of a plurality of battery cells. The processor 120 may, from the balancing capacity of each battery cell, determine a degree by which a capacity of each battery cell has changed as the compensation capacity. For instance, a unit of the balancing capacity of each battery cell may be ampere-hour (Ah), and a unit of the compensation capacity may be percent (%).

The rated capacity may be identical for all battery cells, and may signify an entire capacity of a battery cell. In other words, the processor 120 may compare a rated capacity of each battery cell to a balancing capacity thereof to determine a degree by which a state of a battery cell has changed due to balancing.

For instance, the processor 120 may determine a compensation capacity of each battery cell by the following [Equation 2]. [Equation 2] $Compensation capacity = \left(balancing capacity / rated capacity\right)$

According to an example embodiment, the processor 120 may identify a starting SOC and an ending SOC of each of a plurality of battery cells. The processor 120 may identify a starting SOC and an ending SOC of each battery cell at each operation. For instance, the processor 120 may identify a starting SOC and an ending SOC of each battery cell at each operation from voltage data and/or balancing data obtained from the information obtaining interface 110.

Here, the starting SOC may signify an SOC of each battery cell when an operation of a vehicle starts, or an SOC when balancing of each battery cell starts. Likewise, the ending SOC may signify an SOC of each battery cell when an operation of a vehicle ends, or an SOC when balancing of each battery cell ends.

The processor 120 may identify a starting SOC of a battery cell as an SOC when an operation of a vehicle starts, and an ending SOC as an SOC when an operation of a vehicle ends, and, in a case in which balancing time of a battery cell is determined at an operation starting point in time, briefly determine a compensation voltage during an operation, and may efficiently use system resources.

According to an example embodiment, the processor 120 may determine a reference SOC based on a starting SOC and an ending SOC. The reference SOC may signify a reference for applying a compensation capacity determined to determine a compensation voltage. The processor 120 may determine a reference SOC with respect to each battery cell at each operation.

As described above, according to a construction of a battery cell, an SOC-voltage relation of a battery cell may not be linear. In a case in which an SOC-voltage relation of a battery cell is not linear, a compensation voltage value may significantly vary depending on an SOC point at which a compensation capacity of the battery cell is applied. Therefore, the processor 120 may determine a reference SOC for compensating a battery cell.

According to an example embodiment, a reference SOC may be set as an average of a starting SOC and an ending SOC. For instance, when a starting SOC of a particular battery cell was 80% and an ending SOC thereof was 60% during an operation, a reference SOC with respect to the corresponding battery cell may be set at 70% in the corresponding operation. The processor 120 may set the reference SOC as an average of the starting SOC and the ending SOC to reflect an SOC change of the battery cell in the corresponding operation on average. For instance, the processor 120 may assume that balancing time, which is determined as described above, has been continuously progressed in an SOC section between the starting SOC and the ending SOC to set the reference SOC as the average of the starting SOC and the ending SOC.

According to an example embodiment, a reference SOC may be set as an SOC corresponding to a point at which a linearity of a graph indicating a relation between a voltage and an SOC of a battery cell is greatest in a section between a starting SOC and an ending SOC. The processor 120 may set an SOC corresponding to a point at which a linearity is greatest as a reference SOC in order to prevent an excessive difference from being generated due to application of a compensation capacity of a battery cell.

For instance, an SOC-voltage graph of each battery cell may be provided, and the processor 120 may identify a point at which a linearity is greatest in the SOC-voltage graph of each cell. For instance, the processor 120 may identify a point at which a double differential value of an SOC-voltage graph is smallest, and may set an SOC corresponding to the corresponding point as a reference SOC.

According to an example embodiment, the processor 120 may determine a compensation voltage of each of a plurality of battery cells based on a reference SOC and a compensation capacity. The processor 120 may determine a compensation voltage of each battery cell by applying a compensation capacity based on a reference SOC of each of a plurality of battery cells.

According to an example embodiment, the processor 120 may determine a difference between a voltage corresponding to a reference SOC and a voltage corresponding to a compensation SOC obtained by adding a compensation capacity to the reference SOC, as a compensation voltage of each of a plurality of battery cells. The processor 120 may add a compensation capacity to a reference SOC of each battery cell to determine a compensation SOC of each battery cell. Because passive balancing is assumed, the processor 120 may calculate a compensation SOC by adding a compensation capacity to a reference SOC. On the contrary, in a case in which a balancing operation in a battery pack is active balancing, the processor 120 may calculate a compensation SOC as a value obtained by subtracting a compensation capacity from a reference SOC.

For instance, the processor 120 may determine a voltage value corresponding to a reference SOC and a compensation SOC of each battery cell by using an SOC-voltage graph of each battery cell. As an instance, in a case in which a voltage value of a battery cell corresponding to a reference SOC is x[mV], and a voltage value thereof corresponding to a compensation SOC is y[mV], the processor 120 may determine a compensation voltage of the battery cell as (y-x)[mV]. Here, because the compensation SOC is greater than the reference SOC, y, which is a voltage value corresponding thereto, may also be greater than x.

According to an example embodiment, the processor 120 may determine a cumulative compensation voltage of each battery cell by accumulating a compensation voltage of each of a plurality of battery cells during a predetermined cycle. The processor 120 may determine a cumulative compensation voltage of each battery cell by accumulating compensation voltages of each operation which is performed within a cycle at each cycle.

The processor 120 may determine a cumulative compensation voltage of each battery cell for each cycle, and, in a case in which a cycle is changed, the cumulative compensation voltage of the battery cell may be initialized in order to re-determine the cumulative compensation voltage with respect to a changed cycle.

According to an example embodiment, the processor 120 may obtain a first voltage of each of a plurality of battery cells at a point in time of diagnosis. The point in time of diagnosis may be set for each cycle, and may signify a point in time for determining a voltage deviation of each battery cell by considering a cumulative compensation voltage at each cycle. The point in time of diagnosis may be set under an identical reference with respect to all cycles.

According to an example embodiment, the point in time of diagnosis may be selected at a pause section. For instance, the processor 120 may obtain an OCV of each of a plurality of battery cells at a point in time of diagnosis in a pause section of a battery pack. As an example, a point in time of diagnosis may be selected as a point at which a voltage of a battery cell is equal to or greater than a critical voltage within a pause section. The critical voltage may be a voltage corresponding to 95% of an SOC, for instance.

As another example, the point in time of diagnosis may be determined as a point at which a linearity is greatest in an SOC-voltage graph of a battery cell. The processor 120 may, in order to prevent a compensation voltage from altering by a difference of an SOC-voltage graph of a battery cell depending on a point in the graph, determine a point in time having an SOC corresponding to a point at which a linearity is greatest in the SOC-voltage graph as a point in time of diagnosis.

According to an example embodiment, the processor 120 may determine a first voltage of each of a plurality of battery cells and a second voltage of each battery cell based on a cumulative compensation voltage. The processor 120 may determine the second voltage of each battery cell by correcting the first voltage of each battery cell with the cumulative compensation voltage by considering a state change of the battery cell due to balancing.

According to an example embodiment, the processor 120 may determine a second voltage of each battery cell by adding a cumulative compensation voltage to a first voltage of each of the plurality of battery cells. In order to compensate for a state change of the plurality of battery cells due to balancing, the processor 120 may determine the second voltage by adding the cumulative compensation voltage to the first voltage of each battery cell. For instance, when a first voltage of a first battery cell is 4135 millivolts (mV) and a cumulative compensation voltage of the first battery cell is 5mV at a corresponding cycle at a point in time of diagnosis, the processor 120 may determine a second voltage of the first battery cell as 4140mV.

As such, the processor 120 may identify a voltage of each battery cell at a point in time of diagnosis at each predetermined cycle, and add a cumulative compensation voltage at the corresponding cycle to the identified voltage, thereby determining a second voltage obtained by correcting a state change due to balancing.

According to an example embodiment, the processor 120 may, based on a reference voltage and the second voltage of each of the plurality of battery cells, determine a voltage deviation of each of the plurality of battery cells.

According to an example embodiment, the processor 120 may determine an average of the second voltage of the plurality of battery cells as the reference voltage. Here, the processor 120 may determine a difference between the reference voltage and the second voltage of each of the plurality of battery cells as the voltage deviation of each battery cell.

This is merely an example, and, depending on cases, the processor 120 may use a value determined based on various calculations such as a median value and the like other than an average value of a voltage deviation of each of a plurality of battery cells as a reference voltage.

According to an example embodiment, the processor 120 may determine a variation of the voltage deviation according to the predetermined cycle with respect to each of the plurality of battery cells. For instance, the processor 120 may determine, with respect to each battery cell, a difference of a voltage deviation determined at adjacent cycles as a variation of the voltage deviation of the battery cell.

For instance, when a voltage deviation of an ith (i is a natural number) battery cell at an nth (n is a natural number equal to or greater than 2) cycle is z[mV], and a voltage deviation of an ith battery cell in a previous (n-1th) cycle is w[mV], the processor 120 may determine a variation of the voltage deviation of the ith battery cell with respect to the nth cycle as z-w[mV].

According to an example embodiment, the processor 120 may diagnose a state of each of the plurality of battery cells based on the variation of the voltage deviation of each of the plurality of battery cells. The processor 120 may, by analyzing the variation of the voltage deviation of each battery cell, diagnose a state of the battery cell.

According to an example embodiment, the processor 120 may diagnose each of the plurality of battery cells by comparing a predetermined diagnosis pattern to a pattern of the variation of the voltage deviation of each of the plurality of battery cells. As an example, the processor 120 may perform a micro-short circuit diagnosis of the battery cell.

The processor 120 may, by analyzing the pattern of the variation of the voltage deviation determined with respect to each battery cell, diagnose a state of the battery cell. For instance, the processor 120 may identify the pattern of the variation of the voltage deviation according to a value of the variation of the voltage deviation and a change in the value of the variation of the voltage deviation.

For instance, when the variation of the plurality of voltage deviations, which is determined, is a positive number, and a total sum of the variation of the plurality of voltage deviations is equal to or greater than a predetermined first reference value R1, the processor 120 may, with respect to each battery cell, determine that a pattern of the variation of the voltage deviation corresponds to a first diagnosis pattern, and may diagnose that an internal micro-short circuit has been generated at the battery cell. As an example, the processor 120 may determine the total sum of the variation of the voltage deviation by accumulating the variation of the voltage deviation of the battery cell, and may compare the determined total sum to the first reference value R1.

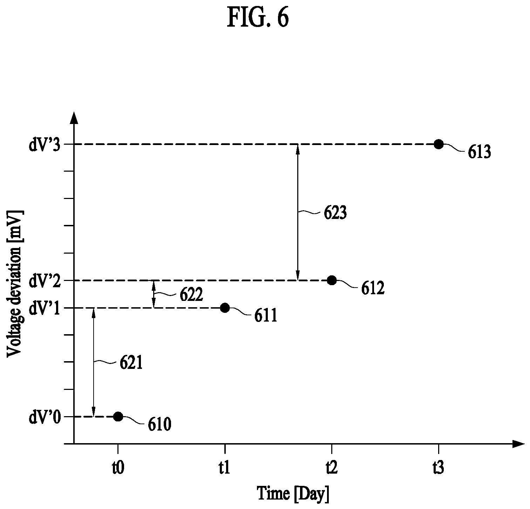

As an example, in FIG. 6, a voltage deviation (e.g., dV'0, dV'1, dV'2, and dV'3) determined at each point in time of diagnosis (e.g., a point in time t0, a point in time t1, a point in time t2, and a point in time t3) are expressed as each point (e.g., a point 610, a point 611, a point 612, and a point 613). Here, a variation of a voltage deviation of a battery cell may signify a difference of a y coordinate of each point. For instance, comparing the point 610 to the point 611, it may be identified that a size of a variation △dV'1 of a voltage deviation with respect to the point in time t1 corresponds to an interval 621, and that a size of the interval 621 is 4mV. Likewise, a size of a variation △dV'2 of a voltage deviation with respect to the point in time t2 may correspond to an interval 622, and the size thereof may be 1mV. Further, a size of a variation △dV'3 of a voltage deviation with respect to the point in time t3 may correspond to an interval 623, and the size thereof may be 5mV. In such a case, because a variation of a voltage deviation is a positive number, and a total sum thereof (△dV'1+△dV'2+△dV'3 = 10mV) is equal to or greater than the first reference value R1, the processor 120 may determine that a pattern of the variation of the voltage deviation corresponds to a first diagnosis pattern.

In another instance, when a variation of a plurality of voltage deviations of a battery cell is equal to or greater than a predetermined second reference value R2, the processor 120 may be configured to determine that a pattern of the variation of the voltage deviation corresponds to a second diagnosis pattern, and diagnose that an internal micro-short circuit has been generated at a battery. For instance, the processor 120 may compare each variation of the voltage deviation of the battery cell to the second reference value R2. The processor 120 may, in a case in which each variation of the voltage deviation is equal to or greater than the second reference value R2, diagnose that an internal micro-short circuit has been generated at the battery.

In an example embodiment, the second reference value R2 may be set at a value less than the first reference value R1. For instance, the first reference value R1 may be set at 10mV, and the second reference value R2 may be set at 2mV.

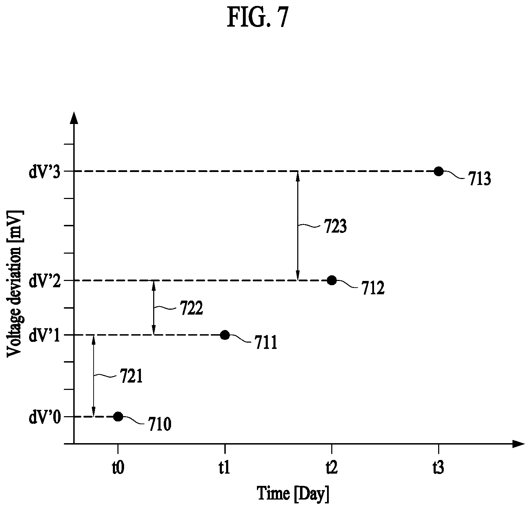

As an example, as in FIG. 7, when a variation of a voltage deviation of each point in time is respectively 3mV (corresponding to an interval 721), 2mV (corresponding to an interval 722), and 4mV (corresponding to an interval 723), because the variation of each voltage deviation is equal to or greater than a second reference value, the processor 120 may determine that a pattern of the variation of the voltage deviation corresponds to a second diagnosis pattern.

In another instance, when a variation of a plurality of voltage deviations is a positive number, and at least one of the variation of the plurality of voltage deviations is equal to or greater than a predetermined third reference value R3, the processor 120 may determine that a pattern of the variation of the voltage deviation corresponds to a third diagnosis pattern, and diagnose that an internal micro-short circuit has been generated at a battery.

In an example embodiment, the third reference value R3 may be configured to be less than the first reference value R1 which is predetermined to correspond to a first diagnosis pattern, and be more than the second reference value R2 which is predetermined to correspond to a second diagnosis pattern. For instance, the first reference value R1 may be set at 10mV, and the second reference value R2 may be set at 2mV, and the third reference value R3 may be set at 6mV.

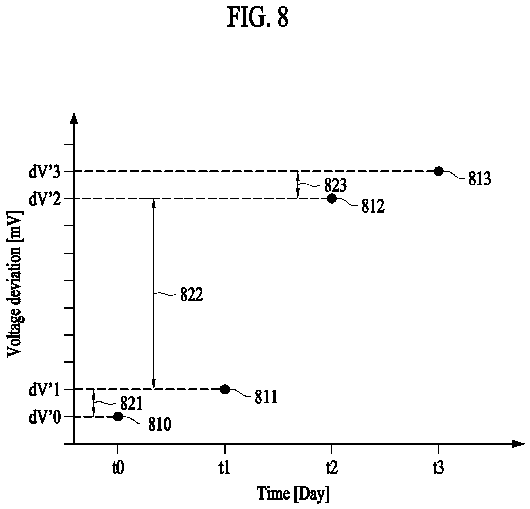

As an example, as in FIG. 8, when a variation of a voltage deviation of each point in time is respectively 1mV (corresponding to an interval 821), 7mV (corresponding to an interval 822), and 1mV (corresponding to an interval 823), because the variation of the voltage deviation with respect to the point in time t2 is equal to or greater than a third reference value, the processor 120 may determine that a pattern of the variation of the voltage deviation corresponds to a third diagnosis pattern.

As such, when a pattern of a variation of a plurality of voltage deviations of a battery cell corresponds to any one diagnosis pattern, the processor 120 may diagnose that an internal micro-short circuit has been generated at the corresponding battery cell. In other words, by sensitively and rigorously diagnosing a state of a battery, the electronic apparatus 10 may prevent in advance a hard short circuit from being generated at the battery under unexpected circumstances.

In another instance, when a variation of a plurality of voltage deviations is a positive number, and the variation of the plurality of voltage deviations increases as time passes, the processor 120 may be configured to determine that a pattern of the variation of the voltage deviation corresponds to a fourth diagnosis pattern, and diagnose that an internal micro-short circuit has been generated at a battery.

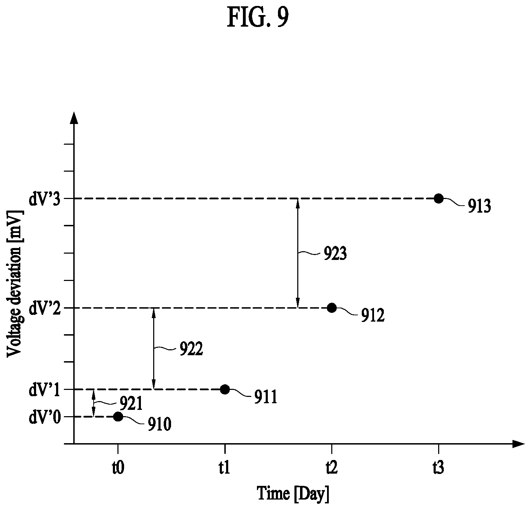

As an example, as in FIG. 9, when a variation of a voltage deviation of each point in time is respectively 1mV (corresponding to an interval 921), 3mV (corresponding to an interval 922), and 4mV (corresponding to an interval 923), because a variation of a diagnosis deviation increases as time passes, the processor 120 may determine that a pattern of the variation of the voltage deviation corresponds to a fourth diagnosis pattern.

According to an example embodiment, the first to fourth diagnosis patterns may presuppose a case in which a variation of a plurality of voltage deviations is a positive number. In other words, as for a battery cell in which an internal micro-short circuit has been generated, as time passes, a voltage deviation thereof from other battery cells may gradually increase. Therefore, according to an example embodiment, in order to efficiently use system resources, the processor 120 may compare a pattern of a variation of a plurality of voltage deviations to a predetermined diagnosis pattern only with respect to a battery cell of which every variation of a plurality of voltage deviations is a positive number.

Meanwhile, when a pattern of a variation of a plurality of voltage deviations corresponds to any one diagnosis pattern, the processor 120 may diagnose that an internal micro-short circuit has been generated at a corresponding battery cell.

Further, when a battery cell is determined to be abnormal as a diagnosis result, the processor 120 may provide information with respect to the abnormal battery cell to a user. As an example, the processor 120 may provide information with respect to the abnormal battery cell to a user terminal through a communication part (not illustrated), and may also provide information with respect to the abnormal battery cell through a display provided at a vehicle, a charger or the like.

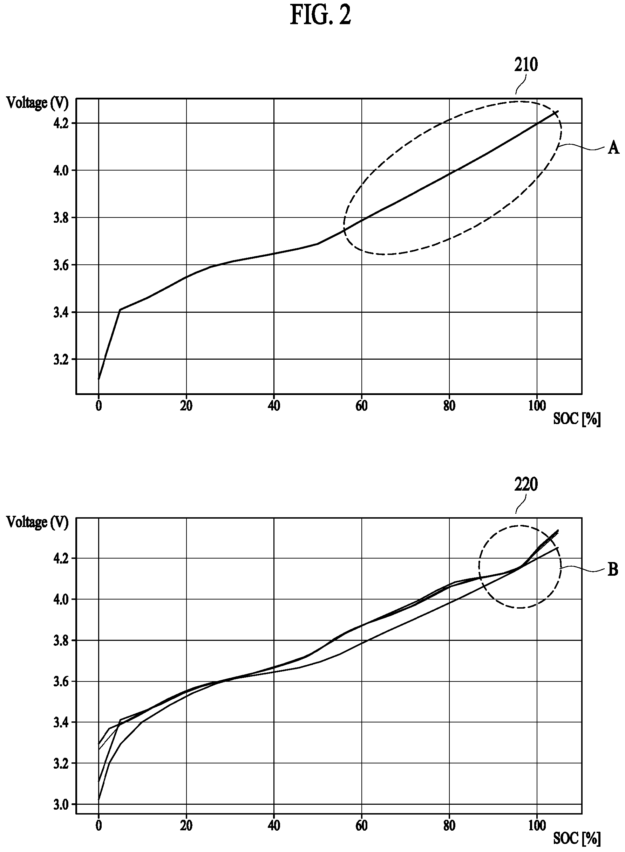

FIG. 2 is a drawing illustrating an example of an SOC-voltage graph of a battery cell according to an example embodiment of the present disclosure.

Referring to FIG. 2, an example of an SOC-voltage graphs of various battery cells are illustrated. Firstly, a graph 210 of FIG. 2 illustrates an example of a battery cell in which an SOC-voltage relation indicates a linearity in a specific SOC area (area A). As in the graph 210, in a case in which an SOC-voltage graph of a battery cell has a linearity, in an area having linearity, even when a compensation voltage is determined by applying a compensation capacity at some point in an area having a linearity, a variance from the compensation voltage may not be significant.

Next, a graph 220 illustrates an example of battery cells of which an SOC-voltage relation does not clearly indicate a linearity. In such a case, a compensation voltage determined as a compensation capacity is applied may significantly vary depending on a point in time of diagnosis. For instance, in a case in which a point in time of diagnosis belongs to an area B of the graph 220, because an inclination of an SOC-voltage curve is high, a correction voltage value may significantly differ depending on a difference of an SOC point corresponding to the point in time of diagnosis. As such, in a case in which a correction voltage value is determined to be great, a change of a battery cell may be determined to be greater than the actual change, thereby leading to mis-diagnosis.

Therefore, the processor 120 may determine a compensation voltage by balancing at each operation to accumulate the same, and use a cumulative compensation voltage value at a point in time of diagnosis, thereby reducing over-inspection and increasing precision in diagnosis.

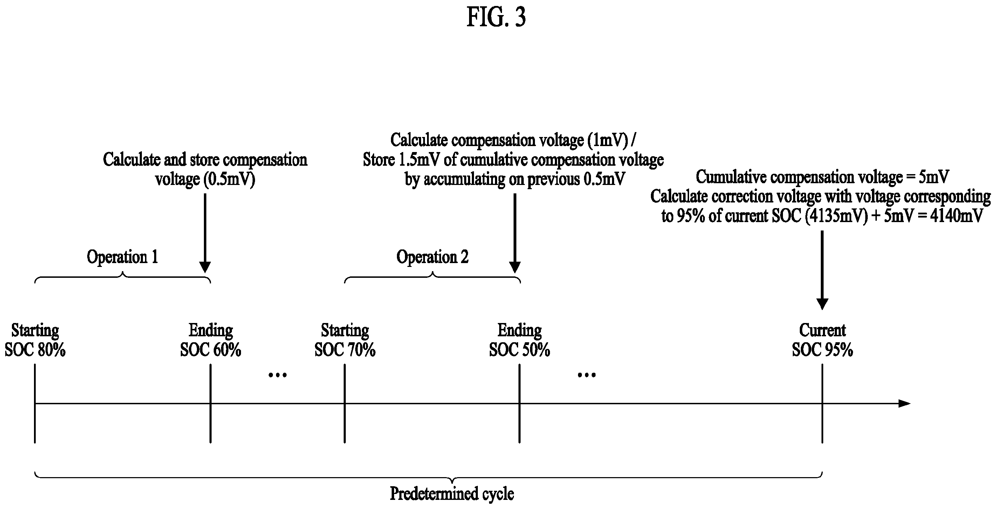

FIG. 3 is a drawing illustrating an example of determining a cumulative compensation voltage of a battery cell according to an example embodiment of the present disclosure.

Referring to FIG. 3, the processor 120 may determine a compensation voltage of a battery cell at each operation, and accumulate the same to determine a cumulative compensation voltage. For instance, in FIG. 3, when a starting SOC of a first battery cell is 80% and an ending SOC thereof is 60% during an operation 1 of a vehicle, the processor 120 may determine a reference SOC as 70%, and may determine a compensation voltage corresponding thereto as 0.5mV.

Likewise, when the starting SOC of the first battery cell is 70%, and the ending SOC thereof is 50% during an operation 2, the processor 120 may determine a reference SOC as 60%, determine a compensation voltage corresponding thereto as 1mV, and determine a cumulative compensation voltage up to the operation 2 as 1.5mV by accumulating the compensation voltage determined in the operation 2 and the compensation voltage determined in the operation 1.

Likewise, when a cumulative compensation voltage, which is accumulated during a predetermined cycle, is 5mV, the processor 120 may add 5mV of the cumulative compensation voltage to 4135mV of a voltage value at a point in time of diagnosis to determine a correction voltage of a battery cell as 4140mV.

In FIG. 3, although a point in time of diagnosis is illustrated as a point in time at which an SOC of a battery cell is 95%, the point in time of diagnosis is not limited thereto.

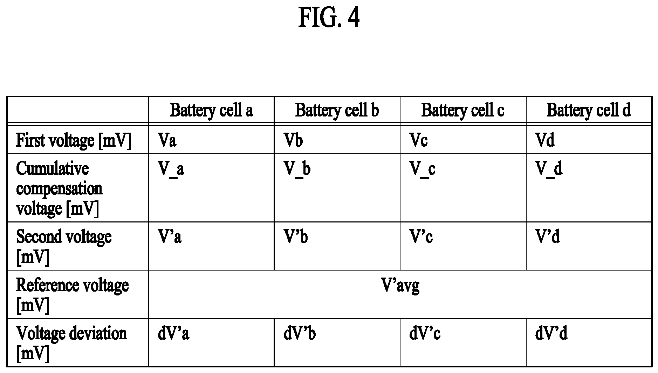

FIG. 4 is a drawing illustrating an example of determining a voltage deviation of a plurality of battery cells according to an example embodiment of the present disclosure.

Referring to FIG. 4, an example of determining a voltage deviation of a plurality of battery cells (a battery cell a to a battery cell d) is illustrated.

The processor 120 may identify a first voltage of the battery cell a, a battery cell b, a battery cell c and the battery cell d at a point in time of diagnosis at each predetermined cycle. For instance, in FIG. 4, a first voltage at a point in time of diagnosis of each battery cell may respectively be Va, Vb, Vc, and Vd.

Further, when a cumulative compensation voltage of each battery cell is V_a, V_b, V_c, and V_d, the processor 120 may determine a second voltage of each battery cell as V'a, V'b, V'c, and V'd. The processor 120 may determine the second voltage by adding a cumulative compensation voltage to the first voltage of each battery cell. For instance, the processor 120 may determine V'a, which is a second voltage of the battery cell a, as Va+V_a.

The processor 120 may determine a difference between a reference voltage and a second voltage of each battery cell as a voltage deviation of each battery cell. For instance, a reference voltage V'avg may be determined with an average of second voltages of battery cells. As an example, the reference voltage may be determined as in V'avg = (V'a + V'b + V'c + V'd)/4.

The processor 120 may determine a voltage deviation of each battery cell as dV'a, dV'b, dV'c, and dV'd. For instance, the processor 120 may determine the voltage deviation of the battery cell c as in dV'c = V'c - V'avg.

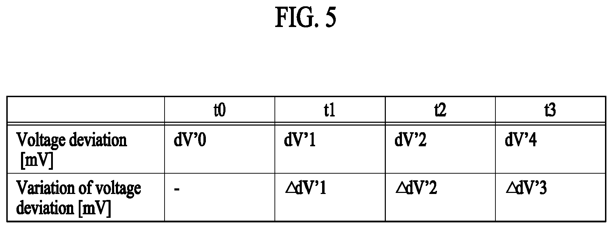

FIG. 5 is a drawing illustrating an example of determining a variation of a voltage deviation of a battery cell according to an example embodiment of the present disclosure.

Referring to FIG. 5, the processor 120 may determine a variation of a voltage deviation with respect to each battery cell, and an example thereof is illustrated. For instance, the processor 120 may determine the voltage deviation (e.g., dV'0, dV'1, dV'2, and dV'3) of a battery cell at the point in time of diagnosis (e.g., the point in time t0, the point in time t1, the point in time t2, and the point in time t3) at each predetermined cycle.

Further, the processor 120 may determine the variation of the voltage deviation determined by each predetermined cycle. For instance, the processor 120 may determine a difference of voltage deviations determined at a current point in time and a previous point in time as a variation of the voltage deviation. For instance, in the point in time t1, the processor 120 may determine a variation of a deviation of a correction voltage corresponding to the point in time t1 as in △dV'1 = dv'1-dv'0.

The processor 120 may analyze a pattern of the variation of the deviation of the correction voltage which is determined as such to diagnose each battery cell.

Although, in FIG. 5, the deviation of the correction voltage is determined at four points in time, and a variation of a deviation of three correction voltages is illustrated, the number of points in time for determining voltage deviation is not limited thereto.

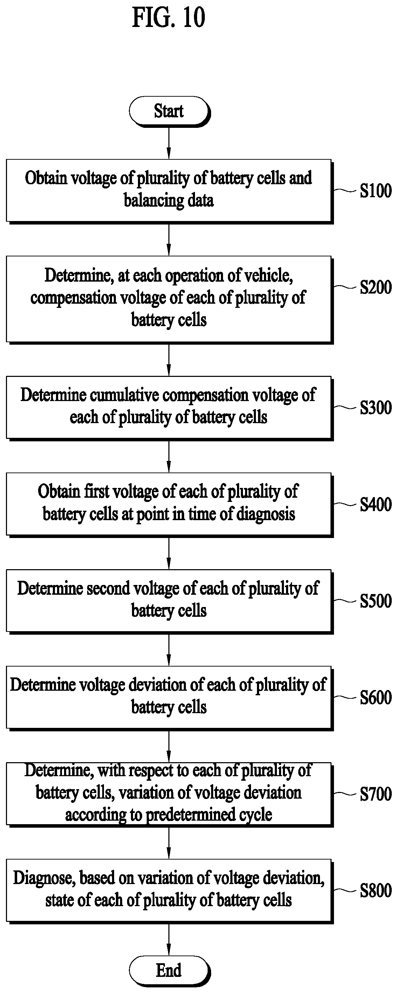

FIG. 10 is a flowchart for illustrating a diagnosing method of an electronic apparatus according to an example embodiment of the present disclosure.

Referring to FIG. 10, in operation S100, the information obtaining interface 110 may obtain voltage and balancing data of a plurality of battery cells.

In operation S200, the processor 120 may determine a compensation voltage of each of the plurality of battery cells at each operation of a vehicle. For instance, the processor 120 may determine a balancing capacity of each of the plurality of battery cells, and may determine the compensation voltage of each battery cell according to the balancing capacity.

In operation S300, the processor 120 may determine a cumulative compensation voltage of each of the plurality of battery cells. For instance, the processor 120 may accumulate the compensation voltage determined in an operation during a predetermined cycle to determine the cumulative compensation voltage of each of the plurality of battery cells.

In operation S400, the processor 120 may obtain a first voltage of each of the plurality of battery cells at a point in time of diagnosis. For instance, the processor 120 may identify and obtain the first voltage of each of the plurality of battery cells based on the voltage data obtained from the information obtaining interface 120.

In operation S500, the processor 120 may determine a second voltage of each of the plurality of battery cells. For instance, the processor 120 may determine the second voltage of each of the plurality of battery cells based on the first voltage of each of the plurality of battery cells and the cumulative compensation voltage.

In operation S600, the processor 120 may determine a voltage deviation of each of the plurality of battery cells. For instance, the processor 120 may, based on a reference voltage and the second voltage of each of the plurality of battery cells, determine the voltage deviation of each of the plurality of battery cells.

In operation S700, the processor 120 may, with respect to each of the plurality of battery cells, determine a variation of the voltage deviation according to the predetermined cycle. For instance, the processor 120 may, with respect to each battery cell, determine a difference of the voltage deviations determined at adjacent cycles as a variation of the voltage deviation.

In operation S800, the processor 120 may diagnose a state of each of the plurality of battery cells based on the variation of the voltage deviation of each of the plurality of battery cells. For instance, the processor 120 may diagnose each of the plurality of battery cells by comparing a predetermined diagnosis pattern to a pattern of the variation of the voltage deviation of each of the plurality of battery cells.

Meanwhile, the present specification and drawings disclose preferred example embodiments of the present disclosure, and although specific terms are used, these are merely used in a general meaning to easily describe the technical content of the present disclosure and to aid understanding of the example embodiments, and not intended to limit the scope of the present disclosure. In addition to the example embodiments disclosed herein, it is apparent to those of ordinary skill in the art to which the present disclosure pertains that other modified examples based on the technical spirit of the present disclosure may be implemented.

The device or terminal according to the above-described example embodiments may include a processor, a memory for storing and executing program data, a permanent storage such as a disk drive, and/or a user object device such as a communication port, a touch panel, a key and/or a button that communicates with an external device. Methods implemented as software modules or algorithms are computer-readable codes or program instructions executable on the processor, and may be stored on a computer-readable recording medium. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network in order for computer-readable codes to be stored and executed in a dispersed manner. The medium may be read by a computer, stored in the memory, and executed by the processor.

The present example embodiments may be represented by functional block configurations and various processing steps. These functional blocks may be implemented by various numbers of hardware and/or software configurations that execute specific functions. For example, the example embodiments may adopt integrated circuit configurations such as a memory, a processor, a logic circuit, and a look-up table that may execute various functions by control of one or more microprocessors or other control devices. Similarly to that elements may be executed by software programming or software elements, the example embodiments may be implemented by programming or scripting languages such as C, C++, Java, assembler, Python and the like including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing. The terms "mechanism", "element", "means", and "configuration" may be widely used and are not limited to mechanical and physical configurations. The terms may include the meaning of a series of routines of software in association with a processor or the like.

## Claims

1. An electronic apparatus comprising:
an information obtaining interface obtaining a voltage of a plurality of battery cells included in a battery pack of a vehicle, and balancing data of the plurality of battery cells;
a memory storing at least one instruction; and
a processor,
wherein, when the at least one instruction is executed, the processor is configured to:
determine, at each operation of the vehicle, a compensation voltage of each of the plurality of battery cells based on the balancing data;
determine, by accumulating the compensation voltage of each of the plurality of battery cells during a predetermined cycle, a cumulative compensation voltage of each of a plurality of battery cells;
obtain a first voltage of each of the plurality of battery cells at a point in time of diagnosis;
determine, based on the first voltage and the cumulative compensation voltage of each of the plurality of battery cells, a second voltage of each of the plurality of battery cells;
determine, based on a reference voltage and the second voltage of each of the plurality of battery cells, a voltage deviation of each of the plurality of battery cells;
determine, with respect to each of the plurality of battery cells, a variation of the voltage deviation according to the predetermined cycle; and
diagnose, based on the variation of the voltage deviation of each of the plurality of battery cells, a state of each of the plurality of battery cells.

2. The electronic apparatus of claim 1, wherein the processor is configured
to:
determine, at each operation of the vehicle, a compensation capacity of each of the plurality of battery cells based on the balancing data;
identify a starting state-of-charge (SOC) and an ending SOC of each of the plurality of battery cells;
determine a reference SOC based on the starting SOC and the ending SOC; and
determine, based on the reference SOC and the compensation capacity, the compensation voltage of each of the plurality of battery cells.

3. The electronic apparatus of claim 2, wherein the processor is configured to:
determine, based on the balancing data, balancing time of each of the plurality of battery cells;
determine, based on a balancing current and the balancing time of each of the plurality of battery cells, a balancing capacity of each of the plurality of battery cells; and
determine, based on a rated capacity and the balancing capacity of each of the plurality of battery cells, the compensation capacity.

4. The electronic apparatus of claim 3, wherein the processor is configured to determine, based on a balancing current and a voltage of each of a plurality of battery cells, the balancing time of each of the plurality of battery cells.

5. The electronic apparatus of claim 2, wherein the processor is configured to determine a difference between a voltage corresponding to the reference SOC and a voltage corresponding to a compensation SOC obtained by adding the compensation capacity to the reference SOC, as the compensation voltage of each of the plurality of battery cells.

6. The electronic apparatus of claim 2, wherein the reference SOC is set with an average of the starting SOC and the ending SOC.

7. The electronic apparatus of claim 2, wherein the reference SOC is set as an SOC corresponding to a point at which a linearity of a graph indicating a relation between a voltage and an SOC of a battery cell is greatest in a section between the starting SOC and the ending SOC.

8. The electronic apparatus of claim 1, wherein the processor is configured to determine the second voltage of each of the plurality of battery cells by adding the cumulative compensation voltage to the first voltage of each of the plurality of battery cells.

9. The electronic apparatus of claim 1, wherein the processor is configured to:
determine an average of the second voltage of the plurality of battery cells as the reference voltage; and
determine a difference between the reference voltage and the second voltage of each of the plurality of battery cells as the voltage deviation of each of the plurality of battery cells.

10. The electronic apparatus of claim 1, wherein the processor is configured to diagnose the plurality of battery cells by comparing a pattern of the variation of the voltage deviation of each of the plurality of battery cells to a predetermined diagnosis pattern.

11. A battery diagnosing method of an electronic apparatus, wherein an operating method of an electronic apparatus comprises:
obtaining a voltage of a plurality of battery cells included in a battery pack of a vehicle and balancing data of the plurality of battery cells;
determining, at each operation of the vehicle, a compensation voltage of each of the plurality of battery cells based on the balancing data;
determining, by accumulating the compensation voltage of each of the plurality of battery cells during a predetermined cycle, a cumulative compensation voltage of each of a plurality of battery cells;
obtaining a first voltage of each of the plurality of battery cells at a point in time of diagnosis;
determining, based on the first voltage and the cumulative compensation voltage of each of the plurality of battery cells, a second voltage of each of the plurality of battery cells;
determining, based on a reference voltage and the second voltage of each of the plurality of battery cells, a voltage deviation of each of the plurality of battery cells;
determining, with respect to each of the plurality of battery cells, a variation of the voltage deviation according to the predetermined cycle; and
diagnosing, based on the variation of the voltage deviation of each of the plurality of battery cells, a state of each of the plurality of battery cells.

12. A non-transitory computer-readable recording medium having a program for executing the method of claim 11 on a computer.
